# EUROPEAN PATENT APPLICATION

(11) **EP 4 668 297 A1**
(43) Date of publication of application: **24.12.2025**
(21) Application number: 24182832.6
(22) Date of filing: 18.06.2024
(51) Int. Cl.: H01F 27/14, H05K 5/06, H05K 7/14

(54) **PRESSURE COMPENSATOR AND SUBSEA TRANSFORMER SYSTEM**

(71) Applicant: Hitachi Energy Ltd, 8050 Zürich (CH)
(72) Inventor: MISSING, Kim, 66510 Vähäkyrö (FI); VIRTANEN, Esa, 65100 Vaasa (FI); OJALAMMI, Heli, 65320 Vaasa (FI)
(74) Representative: Epping - Hermann - Fischer

(57) **Abstract**

In at least one embodiment, the pressure compensator (1) is configured for subsea-use and comprises:
- a first bellows chamber (21) configured to be filled with a first insulation liquid (61),
- an electrical equipment (3) placed in the first bellows chamber (21), and
- electrical feedthroughs (4) connecting the electrical equipment (3) with an exterior of the pressure compensator (1) .

## Description

A pressure compensator is provided. Moreover, a subsea transformer system comprising such a pressure compensator is also provided.

Documents WO 2015/104050 A1, WO 2021/185720 A1 and US 2015/0167704 A1 refer to subsea installations.

Document US 2011/0203379 A1 refers to a subsea pressure compensator.

A problem to be solved is to provide a subsea transformer system that has a reduced number of separate components.

This object is achieved, inter alia, by a pressure compensator and by a subsea transformer system as defined in the independent claims. Exemplary further developments constitute the subject-matter of the dependent claims.

For example, the pressure compensator is for subsea use, especially in salt water. The pressure compensator comprises a first bellows chamber to be filled with a first insulation liquid, an electrical equipment, or any other equipment where likewise fluid compensation and/or cooling and/or insulation is needed, placed in the first bellows chamber, and electrical feedthroughs connecting the electrical equipment with an exterior of the pressure compensator.

The pressure compensator can be used in a subsea transformer system. Thus, a subsea transformer system with a minimized number of components can be achieved, for example.

Normally, liquid filled subsea transformers have tank and external pressure compensators to equalize the internal pressure close to the surrounding water pressure. Auxiliary power transformers are usually placed inside a control pod but in case of an auxiliary transformer failure the complete pod has to be retrieved, for example.

As described herein, the transformer or any other liquidimmersed and/or cooling-requiring device and pressure compensation functions have been combined into a same vessel having double-barrier feature, for example. In other words, the transformer active part with/or any other electrical device, that is, the electrical equipment, is put inside of the pressure compensator. In this solution, there are less components.

The parasite liquid volume of the compensator can thus be used to immerse the electrical equipment, like a transformer active part. With suitable wet-mate subsea connectors, the pressure compensator is a separately retrievable unit and/or a nearby control pod can be retrieved without the pressure compensator. The double-barrier requirement can be fulfilled. Additionally, the compensating position can be visually monitored by a remote operate vehicle, ROV, or with simple position monitoring.

In addition to the before named, the pressure compensator described herein can fulfil the new coming IEC subsea standard IEC 61886-2 Subsea equipment - Part 2: Power transformers, even though an electrical power the pressure compensator with the electrical device is configured for may be below e.g. 50 kVA.

Subsea connectors can be single-barrier bulkhead connectors with termination chamber separately to fulfil double-barrier functionality to main liquid volume or double-barrier connectors penetrating directly to a main liquid volume, for example. Termination chamber can be compensated with dedicated compensator or with a connection to the main pressure compensator intermediate space.

According to at least one embodiment, the pressure compensator is configured for subsea use. This means, for example, that the pressure compensator is made on an exterior with materials that withstand corrosion resulting from salt water. In addition, the pressure compensator may be configured to be put in deep water, for example, at a depth of at least 0.1 km or of at least 0.5 km and/or of at most 5 km or of at most 2 km. That is, the pressure compensator is configured to be operated at comparably high environmental pressures and possibly still being waterproof. Hence, if present, any valves or cavities are configured for pressure changes and absolute pressures from atmospheric pressure to subsea pressure. In addition, the pressure compensator may be configured for typical temperatures present in subsea conditions, like around 4 °C.

According to at least one embodiment, the first bellows chamber is configured to be filled with a first insulation liquid. For example, the first insulation liquid is a transformer insulation liquid, like a transformer oil. The first insulation liquid may be the only fluid present in the first bellows chamber. The term 'fluid' may refer to any liquid and gas and mixture thereof. Especially, the first bellows chamber may be free of any gases or free of any significant amount of gases.

For example, the term 'bellows chamber' or "bellows' means that it is an elastic vessel that can be compressed when pressure is applied to the outside of the vessel, or correspondingly extended under decreased pressure; respectively, it is compressed or extended when the volume of the inner liquid changes due to temperature changes. When the pressure is released to normal pressure, like 1013 hPa, the vessel will return to its original shape when the temperature of the fluid is same as originally, provided the material has not been stressed past its yield strength. The bellows chamber may be used to deform under pressure and to provide a hermetic seal that allows movement.

According to at least one embodiment, the electrical equipment is partially or completely placed in the first bellows chamber. For example, the electrical equipment is in direct contact with the first insulation liquid when the pressure compensator is filled with the first insulation liquid. Thus, the electrical equipment may not be provided with an extra encasing. Hence, the first insulation liquid can be used, for example, for electrically insulating and/or cooling the electrical equipment.

It is possible that there is just one electrical equipment or that there is a plurality of electrical equipments, that is, a plurality of distinct electrical devices. In the following, however, for simplicity only one electrical equipment is mentioned although there can be more than one electrical equipment.

According to at least one embodiment, the electrical feedthroughs connect the electrical equipment with an exterior of the pressure compensator. The exterior is, for example, an electric wiring outside the pressure compensator. It is possible that the electrical feedthroughs are configured to be in direct contact with seawater at an end remote from the electrical equipment. The electrical feedthroughs may be configured to provide electrical insulation against seawater at the voltages the electrical equipment is configured to work with.

According to at least one embodiment, the pressure compensator further comprises a first carrier plate. For example, the first carrier plate is a plane plate. In intended use, the first carrier plate may be mechanically stable and rigid, that is, the first carrier plate may not significantly deform in the intended use of the pressure compensator. Otherwise, the first carrier plate may also have a non-planar shape, like a dome shape.

According to at least one embodiment, the first carrier plate is configured to be horizontally arranged. That is, in intended use a normal vector to the first carrier plate may be aligned vertically, that is, in parallel with a vector of gravity. This applies, for example, with a tolerance of at most 20° or of at most 10° or of at most 5°. Otherwise, the first carrier plate may be configured to be arranged vertically or obliquely, that is, in principle in any other direction.

According to at least one embodiment, the first carrier plate is configured to be arranged in a fixed manner. In other words, the first carrier plate is not a movable part.

According to at least one embodiment, the electrical equipment is carried by the first carrier plate. It is possible that the first carrier plate is the only rigid component of the pressure compensator at which the electrical equipment is mounted. Thus, the electrical equipment may only be in direct contact with the first carrier plate, the first insulating liquid upon being filled in the first bellows chamber, and the feedthroughs. The feedthroughs, however, may not be configured to bear any significant mechanical forces resulting from the electrical equipment. Technically, the electrical equipment could be on the bottom plate but it would yield mechanical stress for the wiring due to the movement.

For example, the electrical equipment hangs on the first carrier plate. That is, the electrical equipment is mounted on a bottom side of the first carrier plate. Alternatively, the electrical equipment seats on the first carrier plate. That is, the electrical equipment is mounted on a top side of the first carrier plate. As used herein, a 'top side' faces a sea surface, and a 'bottom side' faces a seafloor.

According to at least one embodiment, the first carrier plate forms part of the first bellows chamber. For example, the first carrier plate forms a top side of the first bellows chamber, especially when the electrical equipment hangs on the first carrier plate. Otherwise, the first carrier plate may form a bottom side of the first bellows chamber, especially when the electrical equipment seats on the first carrier plate.

According to at least one embodiment, the pressure compensator further comprises a second carrier plate. Analogously to the first carrier plate, the second carrier plate can be a rigid and/or plane plate and may be configured to be horizontally arranged, or also in an arbitrary direction. Otherwise, the second carrier plate may also have a non-planar shape, like a dome shape.

According to at least one embodiment, the second carrier plate is arranged in a movable manner. That is, in the intended use of the pressure compensator the second carrier plate may move at least at times. For example, the second carrier plate may move during a volume compensation of a main tank of a transformer system.

According to at least one embodiment, the second carrier plate forms part of the first bellows chamber. For example, the second carrier plate forms the bottom side of the first bellows chamber, especially when the electrical equipment hangs on the first carrier plate. Otherwise, the second carrier plate may form a top side of the first bellows chamber, especially when the electrical equipment seats on the first carrier plate.

According to at least one embodiment, the pressure compensator further comprises a support frame. For example, the support frame carries the first bellows chamber. That is, for example, the first carrier plate rests on the support frame. By means of the support frame, the pressure compensator may be positioned in the system.

According to at least one embodiment, part of the first bellows chamber is mounted movably at the support frame. For example, said part is the second carrier plate.

According to at least one embodiment, the first bellows chamber comprises an interior side wall. For example, the interior side wall connects the first and second carrier plates. Thus, the first bellows chamber may be defined by the first and second carrier plates together with the interior side wall. The interior side wall may be of tubular shape or may have the shape of a cube jacket. It is possible that the interior side wall is deformable, for example, to compensate for a movement of the second carrier plate. For example, the interior side wall is made of a steel sheet or multiple sheets.

According to at least one embodiment, the support frame comprises one or a plurality of support rods. The at least one support rod may ensure correct positions of the first and second carrier plates relative to one another. By way of example, there is one support rod or there are three support rods or there are four support rods or there are six support rods.

According to at least one embodiment, the second carrier plate is movably mounted at the at least one support rod. For example, the at least one support rod is configured to guide the second carrier plate when moving. The at least one support rod may thus be a guidance rail.

According to at least one embodiment, the support rods constitute legs of the pressure compensator. Thus, the pressure compensator may rest on the support rods. For secure rest, the support rods may have an adjustable length and/or may have hinges and/or may have connectors to be placed and/or fixed, for example, in the transformer system.

According to at least one embodiment, the electrical equipment is partly or completely arranged between the first carrier plate and the second carrier plate. For example, the first and second carrier plates are arranged in parallel with each other.

For example, the second carrier plate is configured to be below the first carrier plate and, thus, forming a bottom side of the pressure compensator, for example. Otherwise, the second carrier plate is configured to be above the first carrier plate and, thus, forming a top side or part of a top side of the pressure compensator and/or of the first bellows chamber.

According to at least one embodiment, the first carrier plate and the second carrier plate are congruent, seen in top view. For example, this applies with a tolerance of at most 20% or at most 10% or at most 5% of an area content of the first carrier plate. However, in the carrier plates do not necessarily have to be congruent.

According to at least one embodiment, the pressure compensator further can comprise a connection chamber. For example, the connection chamber is attached to the first bellows chamber. By way of example, the connection chamber is mounted atop the first carrier plate, or the first carrier plate is mounted atop the connection chamber. Possibly, the connection chamber may rest on the first connection plate or vice versa.

According to at least one embodiment, one or some or all of the electrical feedthroughs comprises a first connector and a second connector. These connectors may be electrical connectors, like plugs. There may be male and female connectors.

According to at least one embodiment, the first and second connectors are located and are correspondingly connected with each other in the connection chamber. Hence, the connection chamber may provide an additional hull around the connectors.

According to at least one embodiment, the connection chamber is configured to be exposed to seawater. Hence, the connection chamber may form part of an exterior hull of the pressure compensator.

According to at least one embodiment, the pressure compensator further comprises a second bellows chamber. For example, the first bellows chamber is arranged in the second bellows chamber. Hence, the second bellows chamber may provide a hull around the first bellows chamber. Hence, the second bellows chamber may provide some protection for the first bellows chamber against environmental effects, like corrosion. The external bellow can be self-compensated or provided with a dedicated separate compensator.

According to at least one embodiment, the second bellows chamber is defined by the first and second carrier plates and by an exterior side wall between the first and second carrier walls. The first and second bellows chambers may be aligned concentrically or also non-concentrically relative to one another.

According to at least one embodiment, the second bellows chamber is configured to be in direct contact with seawater. For example, the exterior side wall is made of a saltresistant material, like rubber or another elastomer.

According to at least one embodiment, the pressure compensator further comprises a supplementary pressure compensator. For example, a first intermediate volume between the first bellows chamber and the second bellows chamber is configured to be filled with a second insulation liquid and/or the connection chamber encloses a second intermediate volume that is configured to be filled with a third insulation liquid. In this case, the supplementary pressure compensator may be configured to compensate for variations of the first intermediate volume and/or the second intermediate volume. The corresponding intermediate volume may be smaller than a volume of the first bellows chamber. For example, said intermediate volumes differ from the volume of the first bellows chamber by at least a factor of two or by at least a factor of five and/or at most by a factor of 10² or at most by a factor of 10. For example, the supplementary pressure compensator is mounted on the first carrier plate and/or is mounted at the connection chamber. Especially the second intermediate volume may also be referred to as a termination volume, the first intermediate volume may also be referred to simply as intermediate volume.

According to at least one embodiment, one or some or all of the electrical feedthroughs emerges from the first bellows chamber where the first bellows chamber is exposed to seawater. Thus, the electrical feedthroughs may directly leave the pressure compensator at the first carrier plate without any connection chamber if they are double-barrier configured, for example.

According to at least one embodiment, the pressure compensator further comprises a visual indicator. For example, the visual indicator is configured to visualize a compression state of the first bellows chamber to the exterior of the pressure compensator. The visual indicator may be based on optical, mechanical, hydraulic and/or electric principles.

According to at least one embodiment, the visual indicator comprises a scale and an indication part movable relative to one another. By means of the scale and the indication part, for example, a relative position of the second carrier plate relative to the support rods may be indicated. Otherwise, the visual indicator may be based on an electrical indication, like providing electrical data for deriving the compression state.

According to at least one embodiment, the electrical equipment comprises or consists of one or of a plurality of the following components: a transformer, a circuit breaker, an inductor, a capacitor and/or a resistor or any equipment where likewise fluid compensation and/or cooling and/or insulation is needed.

According to at least one embodiment, the electrical equipment is configured for handling an electrical power of at most 2 kVA or of at most 10 kVA or of at most 50 kVA.

Alternatively or additionally, said electrical power is at least 1 kVA or is at least 2 kVA or is at least 5 kVA.

According to at least one embodiment, a weight of the electrical equipment is at most 500 kg or is at most 300 kg or is at most 200 kg. Alternatively or additionally, said weight is at least 50 kg or is at least 100 kg.

According to at least one embodiment, an overall volume of the first bellows chamber is at least 20 l or is at least 50 l or is at least 150 l. Alternatively or additionally, said overall volume is at most 2 m³ or is at most 1 m³ or is at most 0.5 m³. The overall volume may be the volume of the first liquid plus the volume of the at least one electrical equipment.

A subsea transformer system is additionally provided. The subsea transformer system comprises a pressure compensator as indicated in connection with at least one of the above-stated embodiments. Features of the pressure compensator are therefore also disclosed for the subsea transformer system and vice versa.

In at least one embodiment, the subsea transformer system comprises a main tank, a power transformer in the main tank, a pressure compensator and a rack. The rack carries the main tank and the pressure compensator.

For example, the subsea transformer system further comprises a main compensator to compensate for volume changes of the main tank. Otherwise, this task may be fulfilled by the pressure compensator in which the electric component or components is/are located.

The pressure compensator can also be a standalone device, separately retrievable for maintenance, for instance, or can be a fixed part of any other system, not necessarily connected to a larger subsea power transformer unit.

A pressure compensator and a subsea transformer system described herein are explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist in understanding.

In the figures:
- Figures 1 to 3: show schematic cross-sectional views of exemplary embodiments of pressure compensators described herein,
- Figure 4: shows schematic perspective representations of an exemplary embodiment of a pressure compensator described herein,
- Figure 5: shows a schematic perspective cross-sectional view of the pressure compensator of Figure 4,
- Figures 6 and 7: show a schematic bottom view and a schematic top view, respectively, of the pressure compensator of Figures 4 and 5,
- Figure 8: shows schematic perspective representations of an exemplary embodiment of a pressure compensator described herein,
- Figure 9: shows a schematic perspective cross-sectional view of the pressure compensator of Figure 8,
- Figures 10 and 11: show a schematic bottom view and a schematic top view, respectively, of the pressure compensator of Figures 8 and 9,
- Figure 12: shows a schematic cross-sectional view of an exemplary embodiment of a subsea transformer system comprising a pressure compensator described herein.
- Figure 13: shows a schematic perspective view of an exemplary embodiment of an electronic equipment for pressure compensators described herein, and
- Figure 14: shows a schematic side view of an exemplary embodiment of a visual indicator for pressure compensators described herein.

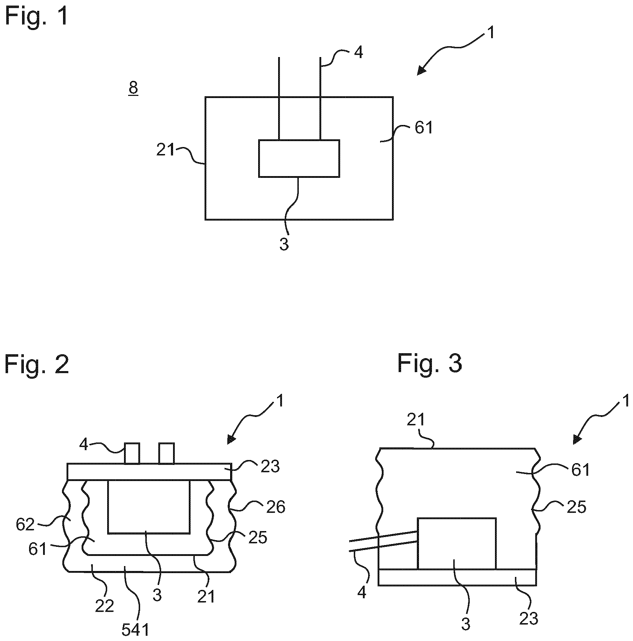

Figure 1 illustrates an exemplary embodiment of a pressure compensator 1. The pressure compensator 1 comprises a first bellows chamber 21 and an electric equipment 3. For example, the electric equipment 3 is an auxiliary transformer configured for a relatively low electric power of, for example, at most 50 kVA. The electric equipment 3 is completely arranged in the first bellows chamber 21. Although only one electric equipment 3 is shown, there can be a plurality of electric equipments 3, also different kinds of electric equipments 3.

The first bellows chamber 21 is configured to be filled with a first insulation liquid 61, like transformer liquid oil. The first bellows chamber 21 may be an elastic vessel that can adapt its enclosed volume to an exterior presser due to being submerged in sea water 8, for example. Thus, an interior pressure of the first bellows chamber 21 may be the same or approximately the same as an exterior pressure next to the first bellows chamber 21 and/or the pressure compensator 1. The first bellows chamber 21 may thus define a sealed volume in which the first insulation liquid 61 is contained.

Further, the pressure compensator 1 includes electrical feedthrough 4. The electrical feedthroughs 4 connect the electric equipment 3 with an exterior of the pressure compensator 1, for example, with a wiring providing power for the electric equipment 3 and providing electrical contact with a component fed by the electric equipment 3, not shown.

In Figure 2, another example of the pressure compensator 1 is illustrated. In this example, the pressure compensator 1 includes a second bellows chamber 22. For example, the first bellows chamber 21 is located within the second bellows chamber 22. That is, the second bellows chamber 22 can provide a second hull around the first bellows chamber 21. Hence, there can be an intermediate volume 541 between the first bellows chamber 21 and the second bellows chamber 22.

Thus, an exterior side wall 26 and a bottom of the pressure compensator 1 may be made of the second bellows chamber 22, and an interior side wall 25 and a top may be made of the first bellows chamber 21 and the first carrier plate 23, respectively. For example, the second bellows chamber 22, that is, the intermediate volume 541 between the hulls of the bellows chambers 21, 22, can be filled with a second insulation liquid 62. The second insulation liquid 62 can be a transformer liquid as well. Especially, the second insulation liquid 62 and the first insulation liquid 61 can be the same substance.

Other than shown, the second bellows chamber 22 may run all around the first bellows chamber 21. As depicted in Figure 2, the first and second bellows chambers 21, 22 may share a first carrier plate 23 as a common wall. For example, the first carrier plate 23 is a plane metal plate, for example, made of steel. It is possible, that the electric equipment 3 is mounted on the first carrier plate 23 in a hanging manner. That is, the electric equipment 3 is applied on a bottom side of the first carrier plate 23. The electrical feedthroughs 4 may be mounted on a top side of the first carrier plate 23. For example, the electrical feedthroughs 4 are wet-mate connectors complying with IEC subsea standard IEC 61886-2: Subsea equipment. Also the overall pressure compensator 1 may comply with said standard.

Such a second bellows chamber 22 and/or such electrical feedthroughs 4 can also be present in all other embodiments.

Otherwise, the same as to Figure 1 may also apply to Figure 2, and vice versa.

According to Figure 3, the first carrier plate 23 forms the bottom of the pressure compensator 1. Thus, the electric equipment 3 rests on the top side of the first carrier plate 23.

As in all other examples it is possible that the electric equipment 3 is distant from the side walls 25 of the first bellows chamber 21 and that it is thus also distant from the second bellows chamber 22.

Optionally, the electrical feedthroughs 4 may run through the side wall 25 of the first bellows chamber 21 and, if present, also through the side walls 26 of the second bellows chamber 22.

Otherwise, the same as to Figures 1 and 2 may also apply to Figure 3, and vice versa.

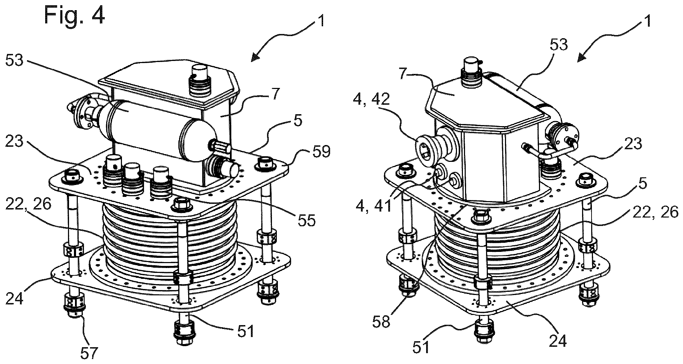

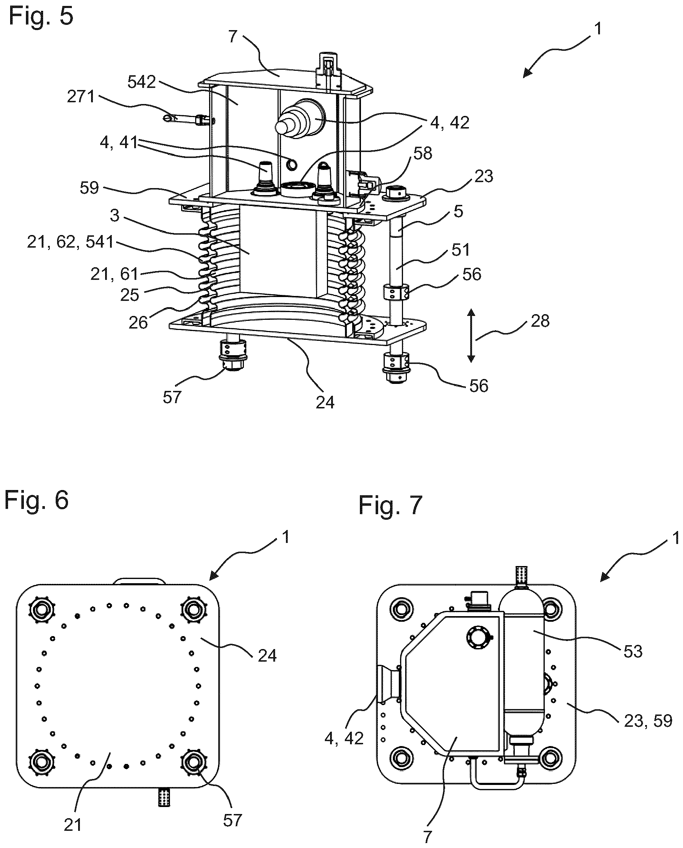

In Figures 4 to 7, another example of the pressure compensator 1 is illustrated in various representations. The pressure compensator 1 comprises both the first bellows chamber 21 and the second bellows chamber 22, for example, in a concentric manner. Both side walls 25, 26 may be in the manner of a corrugated sheet, for example. Between the side walls 25, 26 and, thus, between the first bellows chamber 21 and the second bellows chamber 22 there is again the intermediate volume 541.

The interior side wall 25 can be made of steel while the exterior side wall 26 can be made of a material resistant to salt water, for example, an elastomer like rubber.

In this example, the pressure compensator 1 further comprises a support frame 5. The first carrier plate 23 may be part of the support frame 5 or may be integrated in the support frame 5. Moreover, there is a second carrier plate 24 opposite the first carrier plate 23. The side walls 25, 26 run between the two planar carrier plates 23, 24. Thus, the carrier plates 23, 24 laterally protrude from the second bellows chamber 22 all around, for example.

The electrical equipment 3 is mounted on the first carrier plate 23 in a hanging manner. To do so, the first carrier plate 23 may comprise a panel 58 and a base 59. For example, the side walls 25, 26 are fixed at the base 59. Hence, the panel 58 can be placed onto the first bellows chamber 21 and at the same time the electrical equipment 3 can be put into the first bellows chamber 21. For example, the panel 58 is coupled with the base 59 in a reversible manner, for example, using a seal and bolts, not shown.

As an option, there is one or there is a plurality of maintenance accesses 55 in the base 59 or otherwise in the panel 58. By means of the maintenance accesses 55, the first insulation liquid 61 may be filled into the first bellows chamber 21, for example. Alternatively, the connection chamber 7 can be compensated to the second bellows chamber 22.

Moreover, the pressure compensator 1 comprises a connection chamber 7. The connection chamber 7 encloses a termination volume 542. The connection chamber 7 may be made of steel and is in particular filled with a third insulation liquid 63 which can be the same substance as the first and second insulation liquids 61, 62, for example, that is, a transformer insulation liquid. However, the third insulation liquid 63 may also be a different liquid. In this case, for the electrical feedthroughs 4 it is possible to use dry-mate connectors as the connection chamber 7 provides a second hull.

For example, adjacent to the termination volume 542 there is a first connector 41 configured as a low-voltage device, for example, for a low-voltage side of a transformer as the electrical equipment 3, and there is a second connector 42 configured as a high-voltage device, for a high-voltage side of the electrical equipment 3, for example. In the connection chamber 7, there may optionally be an intermediate wiring between connector parts at the panel 58 and connector parts at a hull of the connection chamber 7, not shown, for example, between the different parts of the first and second connectors 41, 42.

The hull of the connection chamber 7 may be rigid, that is, may not configured for compensating volume changes of the connection chamber 7 due to pressure changes. Otherwise, the hull of the connection chamber 7 may be at least partly of flexible manner, for example, may be formed as an elastic corrugated sheet.

Optionally, the pressure compensator 1 further comprises a supplementary pressure compensator 53. By means of the supplementary pressure compensator 53, changes of the intermediate volume 541 and/or of the termination volume 542 due to temperature changes and/or external pressure changes can be compensated for. For example, by means of the supplementary pressure compensator 53 volume changes of the termination volume 542 are compensated for; for this purpose, the termination volume 542 can be connected with the supplementary pressure compensator 53 by means of a pipe 271. Volume changes of the bellows 21, 22 and especially of the intermediate volume 541 may be compensated for by deformation of the elastic side walls 25, 26.

Optionally, there is no supplementary pressure compensator 53. In this case, the volumes 541, 542 may hydraulically be connected with each other by a connection means, like another pipe or an opening, not illustrated, and the intermediate volume 541 may thus serve as a pressure compensation volume for the termination volume 542.

As a further option, the support frame 5 comprises a plurality of support rods 51, for example, four of the support rods 51. The support rods 51 may fixedly be connected with he first carrier plate 23. However, the second carrier plate 24 can slide along the support rods 51 and is guided by the support rods 51 so that volume compensation of the first and second bellows chambers 21, 22 is enabled by guided movement of the second carrier plate 24 along a direction of movement 28.

For example, the supplementary pressure compensator 53 is mounted at the connection chamber 7. Otherwise, the optional supplementary pressure compensator 53 can also be mounted at the support frame 5, especially if there is no connection chamber 7 or if there is only a relatively small connection chamber 7.

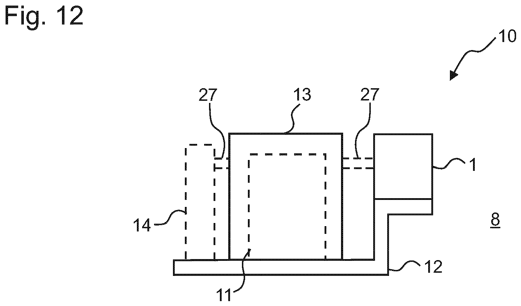

Optionally, the support rods 51 each comprise a pedestal 57. It is possible that the pressure compensator 1 can be mounted onto a rack 12 of a subsea transformer system 10, compare also Figure 12. Thus, the pedestals 57 may comprise fixing means like hinges and/or screw threads. Moreover, the pedestals 57 may allow a length adjustment of the support rods 51 and, thus, horizonal alignment of the pressure compensator 1, if needed.

As a further option, there may be movement limitations 56 at the support rods 51. By means of the movement limitations 56, movement of the second carrier plate 24 along the direction 28 can be restricted so that damage to the second carrier plate 24, the side walls 25, 26 and the electrical equipment 3 due to excess movement can be prevented. The movement limitations 56 may be metallic or plastic parts.

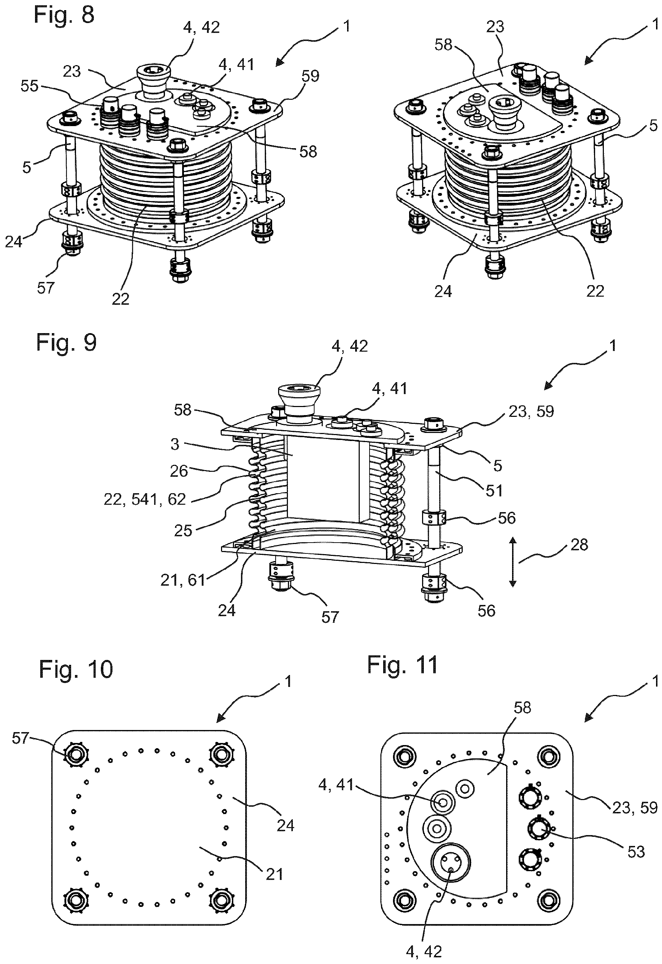

Figures 4 to 7 are drawn true to scale; the size and length proportions in said Figures may thus apply individually or in any combination as shown, for example, with a tolerance of at most a factor of three or of at most a factor of two or of at most a factor of 1.2. The same may apply for Figures 8 to 11.

Otherwise, the same as to Figures 1 to 3 may also apply to Figures 4 to 7, and vice versa.

Figures 8 to 11 describe another example of the pressure compensator 1. Concerning the bellows chamber 21, 22, the carrier plates 23, 24 and the support frame 5, the same may apply as to Figures 4 to 7. However, there is no connection chamber 7. Thus, the connectors 4, 41, 42 directly emerge from the panel 58 to the surrounding seawater when the pressure compensator is submerged. Hence, the connectors 4, 41, 42 may be wet-mate connectors.

In Figures 4 to 7 and 8 to 11, respectively, the electrical equipment 3 is mounted in a hanging manner. However, it is alternatively also possible that the electrical equipment 3 is mounted onto the first carrier plate 23 in a seating manner, analogously to Figure 3. In this case, if present, the connection chamber 7 may be below the bellows chambers 21, 22. Optionally, the movably mounted second carrier plate 24 forms the top of the pressure compensator 1. Further optionally, the second carrier plate 24 may be provided with the base 59 and the panel 58 instead of the first carrier plate 23.

If the electrical equipment 3 is mounted in a seating manner, it is also possible that the with the first carrier plate 23 being the electrical equipment 3 is just put onto the second carrier plate 24 and using electric wiring between the first carrier plate 23 and the electrical feedthroughs 4 through the first bellows chamber 21 so that only very few changes are required to the configuration as shown in Figures 4 to 7 and 8 to 11, respectively.

Otherwise, the same as to Figures 1 to 7 may also apply to Figures 8 to 11, and vice versa.

Concerning the first and second bellows chambers 21, 22, reference is also made to document US 2011/0203379 A1, the disclosure content of which is hereby incorporated by reference, see especially Figure 1 and paragraphs 18 to 39 of said document.

In Figure 12, an example of a subsea transformer system 10 is shown. The subsea transformer system 10 comprises a main tank 13, a power transformer 11 in the main tank 13, the pressure compensator 14 and the rack 12 carrying the main tank 13 and the pressure compensator 1.

However, the pressure compensator 1 can also be a standalone device, separately retrievable for maintenance, for instance, or can be a fixed part of another system, not necessarily connected to a larger power transformer unit.

For example, the power transformer 11 is configured for an electrical power of at least 0.1 MVA or of at least 0.5 MVA and/or of at most 5 MVA or of at most 2 MVA. It is possible that the power transformer 11 is configured for an electrical power that exceeds the electrical power the electrical equipment 3 is configured for by at least a factor of 10 or by at least a factor of 10² and/or by at most a factor of 10⁴ or by at most a factor of 10³.

It is possible that the main tank 13 and the pressure compensator 1 are hydraulically separated components despite being submerged in the seawater 8. In other words, it is possible that no insulation liquid is exchanged between the main tank 13 and the pressure compensator 1. In this case, for pressure compensation of the main tank 13 there can be a main compensator 14 coupled to the main tank 13 by means of a pipe 27. Otherwise, it could also be possible that the pressure compensator 1 serves as the main compensator 14; in this case, the main tank 13 and the pressure compensator 1 are hydraulically coupled, for example, by means of the pipe 27 between them. These options are indicated in Figure 12 with dashed lines.

Otherwise, the same as to Figures 1 to 11 may also apply to Figure 12, and vice versa.

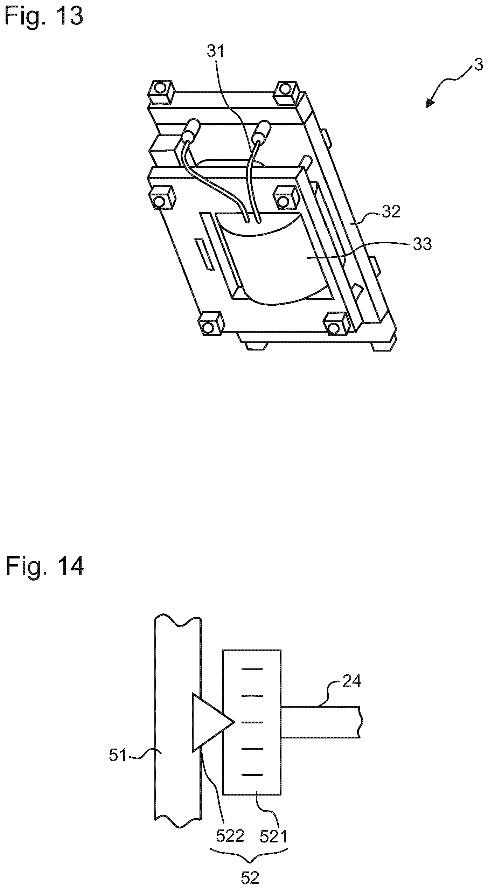

In Figure 13, an example of the electrical equipment 3 is illustrated. In this case, the electrical equipment 3 is a transformer configured for a relatively low electric power. Thus, the electrical equipment 3 comprises windings 33 framed in a mechanical structure 32, for example, which could comprise or could be made of soft iron, for example. The windings 33 can be addressed by a wiring 31.

Otherwise, the same as to Figures 1 to 12 may also apply to Figure 13, and vice versa.

Optionally, all embodiments of the pressure compensator 1 may include one or a plurality of visual indicators 52, compare Figure 14. For example, the visual indicator 52 is composed of an indication part 522 which may be fixed, for example, at one of the support rods 51. A scale 521 can be fixed on the second carrier plate 24 which is guided by the support rods 51. Otherwise, the scale 521 can be attached to the respective support rod 51 and the indication part 522 can be coupled to the second carrier plate 24.

For checking the relative position of the second carrier plate 24 and, thus, the volume of the first bellows chamber 21, in particular, a remote operate vehicle, ROV for short, carrying a camera can be used. Other than optical indicators 52, electric and/or hydraulic indicators are possible as well.

The components shown in the figures follow, unless indicated otherwise, exemplarily in the specified sequence directly one on top of the other. Components which are not in contact in the figures are exemplarily spaced apart from one another. If lines are drawn parallel to one another, the corresponding surfaces may be oriented in parallel with one another. Likewise, unless indicated otherwise, the positions of the drawn components relative to one another are correctly reproduced in the figures.

The invention described here is not restricted by the description on the basis of the exemplary embodiments. Rather, the invention encompasses any new feature and also any combination of features, which includes in particular any combination of features in the patent claims, even if this feature or this combination itself is not explicitly specified in the patent claims or exemplary embodiments.

### List of Reference Signs

- 1: pressure compensator
- 21: first bellows chamber
- 22: second bellows chamber
- 23: first carrier plate
- 24: second carrier plate
- 25: interior side wall
- 26: exterior side wall
- 27: pipe
- 271: pipe
- 28: direction of movement
- 3: electrical equipment
- 31: wiring
- 32: mechanical structure
- 33: winding
- 4: electrical feedthrough
- 41: first connector
- 42: second connector
- 5: support frame
- 51: support rod
- 52: visual indicator
- 521: scale
- 522: indication part
- 53: supplementary pressure compensator
- 541: first intermediate volume
- 542: termination volume (second intermediate volume)
- 55: maintenance access
- 56: movement limitation
- 57: pedestal
- 58: panel
- 59: base
- 61: first insulation liquid
- 62: second insulation liquid
- 63: third insulation liquid
- 7: connection chamber
- 8: seawater
- 10: subsea transformer system
- 11: power transformer
- 12: rack
- 13: main tank
- 14: main compensator

## Claims

1. A pressure compensator (1) configured for subsea-use comprising:
- a first bellows chamber (21) configured to be filled with a first insulation liquid (61),
- an electrical equipment (3) placed in the first bellows chamber (21), and
- electrical feedthroughs (4) connecting the electrical equipment (3) with an exterior of the pressure compensator (1) .

2. The pressure compensator (1) according to the preceding claim,
further comprising a first carrier plate (23) configured to be horizontally arranged in a fixed manner,
wherein the electrical equipment (3) is carried by the first carrier plate (23),
wherein the first carrier plate (23) forms part of the first bellows chamber (21).

3. The pressure compensator (1) according to any one of the preceding claims,
further comprising a second carrier plate (24) configured to be horizontally arranged in a movable manner,
wherein the second carrier plate (24) forms part of the first bellows chamber (21).

4. The pressure compensator (1) according to any one of the preceding claims,
further comprising a support frame (5) carrying the first bellows chamber (21),
wherein part of the first bellows chamber (21) is mounted movably at the support frame (5).

5. The pressure compensator (1) according to claim 3 and according to the preceding claim,
wherein the support frame (5) comprises one or a plurality of support rods (51),
wherein the second carrier plate (24) is movably mounted at the support rods (51) so that the support rods (51) are configured to guide the second carrier plate (24) when moving.

6. The pressure compensator (1) according to claim 2 and according to the preceding claim,
wherein the electrical equipment (3) is arranged between the first carrier plate (23) and the second carrier plate (24), wherein the second carrier plate (24) is configured to be below the first carrier plate (23),
wherein the first carrier plate (23) and the second carrier plate (24) are congruent, seen in top view,
wherein the second carrier plate (24) is configured to be below the first carrier plate (23).

7. The pressure compensator (1) according to claim 2 and according to claim 6,
wherein the electrical equipment (3) is arranged between the first carrier plate (23) and the second carrier plate (24), wherein the second carrier plate (24) is configured to be above the first carrier plate (23),
wherein the support rods (51) are configured to guide the second carrier plate (24) along a vertical direction.

8. The pressure compensator (1) according to any one of the preceding claims,
further comprising a connection chamber (7) attached to the first bellows chamber (21),
wherein at least one of the electrical feedthroughs (4) comprises a first connector (41) and a second connector (42) being connected in the connection chamber (7),
wherein the connection chamber (7) is configured to be exposed to seawater (8).

9. The pressure compensator (1) according to any one of the preceding claims,
further comprising a second bellows chamber (22) configured to be in direct contact with seawater (8),
wherein the first bellows chamber (21) is arranged in the second bellows chamber (22).

10. The pressure compensator (1) according to claim 8 and according to the preceding claim, further comprising a pipe connecting the connection chamber (7) and the second bellows (22) without presence of a supplementary pressure compensator.

11. The pressure compensator (1) according to claims 8 and 9, further comprising a supplementary pressure compensator (53), wherein the supplementary pressure compensator (53) is configured to compensate for variations of a termination volume (542) of the connection chamber (7) and/or of an intermediate volume (541) between the first bellows chamber (21) and the second bellows chamber (22).

12. The pressure compensator (1) according to any one of the preceding claims,
wherein at least one of the electrical feedthroughs (4) emerges from the first bellows chamber (21) where the first bellows chamber (21) is exposed to seawater (8).

13. The pressure compensator (1) according to any one of the preceding claims,
further comprising a visual indicator (52) configured to visualize a compression state of the first bellows chamber (21) to the exterior of the pressure compensator (1), wherein the visual indicator (52) comprises a scale (521) and an indication part (522) movable relative to one another.

14. The pressure compensator (1) according to any one of the preceding claims,
wherein the electrical equipment (3) comprises at least one of a transformer, a circuit breaker, an inductor, a capacitor, or a resistor,
wherein the electrical equipment (3) is configured for handling an electrical power of up to 50 kVA.

15. A subsea transformer system (10) comprising a main tank (13), a power transformer (11) in the main tank (13), a pressure compensator (1) and a rack (12) carrying the main tank (13) and the pressure compensators (1), (14).
